# EUROPÄISCHE PATENTSCHRIFT

(11) **EP 2 308 142 B1**
(45) Veröffentlichungstag und Bekanntmachung des Hinweises auf die Patenterteilung: **25.04.2012**
(21) Anmeldenummer: 09775899.9
(22) Anmeldetag: 17.06.2009
(51) Int. Cl.: H01S 5/14, H01S 5/183, H01S 5/10, H01S 3/109

(54) **HALBLEITERLASER MIT EINEM OPTISCH NICHTLINEAREN KRISTALL**
SEMICONDUCTOR LASER HAVING AN OPTICALLY NON-LINEAR CRYSTAL
LASER À SEMI-CONDUCTEURS CONTENANT UN CRISTAL OPTIQUEMENT NON-LINÉAIRE

(30) Priorität: 04.08.2008 DE 102008036254
(43) Veröffentlichungstag der Anmeldung: 13.04.2011
(73) Patentinhaber: OSRAM Opto Semiconductors GmbH, 93055 Regensburg (DE)
(72) Erfinder: KUEHNELT, Michael, 93051 Regensburg (DE); BRICK, Peter, 93051 Regensburg (DE); LUTGEN, Stephan, 93047 Regensburg (DE)
(74) Vertreter: Epping - Hermann - Fischer
(86) Internationale Anmeldenummer: PCT/DE2009/000862
(87) Internationale Veröffentlichungsnummer: WO 2010/015221

(56) Entgegenhaltungen:
- WO-A-2006/105249
- WO-A-2008/070911
- DE-A1- 4 205 587
- DE-A1-102004 011 456
- US-B1- 6 373 868
- HARTKE R ET AL: "Efficient green generation by intracavity frequency doubling of an optically pumped semiconductor disk laser" APPLIED PHYSICS B ; LASERS AND OPTICS, SPRINGER, BERLIN, DE, Bd. 87, Nr. 1, 20. Januar 2007 (2007-01-20), Seiten 95-99, XP019490571 ISSN: 1432-0649

## Beschreibung

Es wird ein Halbleiterlaser angegeben.

Auf Halbleitern basierende Laser bieten gegenüber etwa Gas- oder Halbleiterlasern mit einem optisch gepumpten YAG- oder YLF-Kristall als Verstärkermedium große Vorteile bezüglich Wirkungsgrad, Wartungsaufwand und Größe des Bauteils. Der zugängliche Wellenlängenbereich aufgrund der Bandlücke des Halbleitermaterials von Halbleiterlaserelementen liegt allerdings oft im nahinfraroten Spektralbereich. Um in den sichtbaren Spektralbereich zu gelangen, ist es für im Nahinfraroten emittierende Laser daher erforderlich, die ursprünglich vom Halbleiterlaserelement emittierte Frequenz zu konvertieren, beispielsweise zu verdoppeln. Das Frequenzmischen beziehungsweise die Frequenzkonversion ist in der Regel ein optisch nichtlinearer Effekt, der abhängig von der Lichtintensität ist. Um eine hohe Effizienz zu erzielen, findet die Frequenzmischung aufgrund der höheren Lichtintensität daher bevorzugt innerhalb eines Laserresonators statt.

In der Druckschrift DE 10 2004 011 456 A1 ist ein oberflächenemittierender Halbleiterlaser mit einem Interferenzfilter angegeben.

Eine zu lösende Aufgabe besteht darin, einen Halbleiterlaser anzugeben, der eine hohe Effizienz bei der Frequenzkonversion aufzeigt.

Es weist der Halbleiterlaser ein Halbleiterlaserelement auf, das dazu ausgestaltet ist, im Betrieb elektromagnetische Strahlung mit mindestens einer Pumpwellenlänge beziehungsweise Fundamentalwellenlänge zu emittieren. Das Halbleiterlaserelement selbst kann elektrisch oder optisch gepumpt sein. Es ist möglich, dass das Halbleiterlaserelement auf einem vertikal emittierenden Laser, einem so genannten Vertical External Cavity Surface Emitting Laser oder VECSEL, basiert. Das Halbleiterlaserelement kann mehrere aktive Schichten aufweisen und als so genanntes Multi-Quantum-Well-Laserelement ausgestaltet sein. Bevorzugt emittiert das Halbleiterlaserelement bei mindestens einer Fundamentalwellenlänge im roten oder nahinfraroten Spektralbereich.

Der Halbleiterlaser weist einen Endspiegel auf. Der Endspiegel kann als dielektrischer Spiegel ausgestaltet sein. Es kann der Endspiegel sowohl für die Fundamentalwellenlänge als auch für eine aus Konversion der Fundamentalwellenlänge erzeugte Wellenlänge reflektierend mit einem Reflexionskoeffizienten größer oder gleich 0,95, insbesondere hochreflektierend mit einem Reflexionskoeffizienten größer oder gleich 0,99, gestaltet sein.

Der Halbleiterlaser umfasst einen polarisationsabhängig reflektierenden Umlenkspiegel. "Polarisationsabhängig reflektierend" bedeutet, dass der Umlenkspiegel beispielsweise Licht mit einer Polarisationsrichtung senkrecht zur Einfallsebene bezüglich des Umlenkspiegels effizient reflektiert beziehungsweise unterstützt. Mit anderen Worten ist der Reflexionsgrad des Umlenkspiegels für eine Polarisationsrichtung deutlich größer als für eine andere Polarisationsrichtung. Bevorzugt beträgt der Unterschied in der Reflektivität mindestens 10 %, insbesondere mindestens 15 %.

Ebenso wie der Endspiegel kann der Umlenkspiegel als dielektrischer Spiegel ausgestaltet sein. Bezüglich der Fundamentalwellenlänge wirkt der Umlenkspiegel für Licht der unterstützten Polarisationsrichtung bevorzugt hochreflektierend, für eine aus der Fundamentalwellenlänge erzeugte Wellenlänge kann der Umlenkspiegel, auch unabhängig von der Polarisationsrichtung, hochreflektierend, teilreflektierend oder transmittierend sein.

Licht mit einer Polarisationsebene senkrecht zur Einfallsebene des Umlenkspiegels wird im Folgenden als senkrecht polarisiert bezeichnet, Licht mit einer Polarisationsrichtung parallel zur Einfallsebene als parallel polarisiertes Licht.

Es befindet sich der polarisationsabhängig reflektierende Umlenkspiegel zwischen dem Halbleiterlaserelement und dem Endspiegel. "Zwischen" bedeutet hierbei, dass Licht, das vom Halbleiterlaserelement emittiert wird, zuerst auf den Umlenkspiegel trifft, von diesem reflektiert und in der Richtung geändert wird, und weiterhin zum Endspiegel gelangt. Halbleiterlaserelement, Endspiegel und Umlenkspiegel bilden mindestens einen Teil eines Resonators des Halbleiterlasers.

Gemäß zumindest einer Ausführungsform des Halbleiterlasers wird ein Endspiegel des Resonators des Halbleiterlasers durch eine dielektrische Schichtenfolge an einer aktiven Schicht oder Schichtenfolge des Halbleiterlaserelements gebildet, wobei die dielektrische Schicht sich auf der dem Umlenkspiegel abgewandten Seite der aktiven Schicht befindet. Durch einen solchen, im Halbleiterlaserelement integrierten Endspiegel des Resonators des Halbleiterlasers kann der Halbleiterlaser sehr kompakt aufgebaut sein.

Der Halbleiterlaser umfasst mindestens einen optisch nichtlinearen Kristall, der für eine Frequenzkonversion vom Typ II der Fundamentalwellenlänge gestaltet ist. Dies bedeutet, dass der optisch nichtlineare Kristall mindestens zwei Kristallachsen aufweist, das heißt, der Kristall ist ein optisch anisotropes Medium. Entlang einer Kristallachse ist der Brechungsindex und somit die Lichtgeschwindigkeit im Kristall verschieden bezüglich zu einer anderen Kristallachse. Außerdem ist der Brechungsindex entlang der Kristallachsen abhängig von der Polarisationsrichtung und der Wellenlänge des Lichts.

Eine Richtung im Kristall, in der senkrecht und parallel polarisiertes Licht dieselbe Ausbreitungsgeschwindigkeit im Kristall aufweisen, wird als optische Achse des Kristalls bezeichnet. Licht, das eine Polarisationsrichtung senkrecht zur optischen Achse aufweist, wird als ordentlich polarisiertes Licht, Licht mit einer Polarisationsrichtung parallel zur optischen Achse wird als außerordentlich polarisiert bezeichnet. Ist der Kristall für eine Frequenzkonversion vom Typ II angeordnet, so bedeutet dies, dass das im Resonator laufende, etwa linear senkrecht polarisierte Licht im Kristall zu gleichen Anteilen in eine außerordentlich und eine ordentlich polarisierte Komponente zerlegt werden kann. Somit kann das Licht im Kristall als in zwei Komponenten unterschiedlicher Polarisationsrichtung aufgespalten angesehen werden, die mit einer unterschiedlichen Geschwindigkeit durch den Kristall propagieren. Mit anderen Worten setzt sich das Licht der Fundamentalwellenlänge aus einem ordentlich und einem außerordentlich polarisierten Anteil zusammen.

Es erfüllt der optisch nichtlineare Kristall eine λ/2-Bedingung. Das bedeutet, der Kristall hat eine solche Länge, dass der Laufzeitunterschied zwischen ordentlich und außerordentlich polarisierten Komponenten des Lichts im Kristall einem Vielfachen der halben Wellenlänge des Lichts entspricht. Ist die Ausbreitungsgeschwindigkeit beispielsweise der ordentlich polarisierten Komponente größer als die der außerordentlich polarisierten, so überholt die ordentlich polarisierte Komponente die außerordentlich polarisierte also um n/2 Wellenlängen, wobei n eine natürliche Zahl ist.

Der Brechungsindex des Kristalls ist, sowohl für ordentlich als auch für außerordentlich polarisiertes Licht, abhängig von der Wellenlänge des Lichts. Die Verwendung eines Typ II-Kristalls bedeutet ebenfalls, dass die für eine beispielsweise Frequenzverdoppelung erforderliche Phasenanpassungsbedingung erfüllt ist. Das heißt im Falle der Frequenzverdopplung, dass in Ausbreitungsrichtung des Lichts der Brechungsindex für die Fundamentalwellenlänge gleich dem Brechungsindex der durch Konversion erzeugten Wellenlänge ist. Dies kann erzielt werden, indem Licht der Fundamentalwellenlänge und durch Konversion erzeugtes Licht unterschiedliche Polarisationsrichtungen aufweisen und/oder der Kristall entsprechend ausgerichtete Kristallachsen hat, so dass Licht der Fundamentalwellenlänge und durch Konversion erzeugtes Licht gleich schnell durch den Kristall propagieren.

Weiterhin ist der Kristall so gestaltet, dass durch die auftretenden optischen Leistungen im normalen Betrieb des Halbleiterlasers keine Zerstörung des optisch nichtlinearen Kristalls auftritt.

Somit umfasst der Halbleiterlasers ein Halbleiterlaserelement, das im Betrieb elektromagnetische Strahlung mit mindestens einer Fundamentalwellenlänge emittiert, einen Endspiegel, einen polarisationsabhängig reflektierenden Umlenkspiegel, der sich zwischen Halbleiterlaserelement und Endspiegel befindet, und mindestens einen optisch nichtlinearen Kristall, der für ein Frequenzmischen vom Typ II der Fundamentalwellenlänge gestaltet ist und der eine λ/2-Bedingung für die Fundamentalwellenlänge erfüllt.

Ein solcher Halbleiterlaser weist eine schmalbandige Emission der Fundamentalwellenlänge auf und ermöglicht eine hohe Effizienz beim Frequenzmischen.

Der Resonator des Halbleiterlasers weist also ein polarisationsselektives Element, nämlich den polarisationsabhängig reflektierenden Umlenkspiegel, auf. Dadurch wird im Resonator nur Licht der Fundamentalwellenlänge beispielsweise mit senkrechter Polarisation verstärkt. Zusätzlich ist der optisch nichtlineare Kristall als λ/2-Element gestaltet. Das bedeutet, dass für gewisse Wellenlängen λ die Polarisationsrichtung des durch den Kristall laufenden Lichts erhalten bleibt. Wie beschrieben, wird das beispielsweise senkrecht polarisierte Licht im Kristall in einen ordentlich und einen außerordentlich polarisierten Anteil zerlegt. Die λ/2-Bedingung bedeutet, dass der Laufzeitunterschied einem Vielfachen der halben Lichtwellenlänge entspricht. Dies heißt, dass diese Bedingung bei einem gegebenen Kristall einer bestimmten Länge nur für bestimmte Wellenlängen λ erfüllt ist, da der λ/2-Effekt vom Brechungsindex und somit von der Wellenlänge des Lichts abhängt. Licht mit nicht passenden Wellenlängen erfährt eine effektive Drehung der Polarisationsrichtung und wird nicht verstärkt. Mit anderen Worten ist Licht mit nicht passenden Wellenlängen nach einem Durchgang durch den Kristall nicht mehr zum Beispiel senkrecht, sondern etwa elliptisch polarisiert und erfährt stärkere Umlaufverluste am polarisationsabhängig reflektierenden Umlenkspiegel. Die Kombination von polarisationsabhängig reflektierendem Umlenkspiegel und optisch nichtlinearem Kristall, der eine λ/2-Bedingung erfüllt, wirkt also als wellenlängenselektive Einheit beziehungsweise als Filter.

Gemäß zumindest einer Ausführungsform des Halbleiterlasers sind Endspiegel und Umlenkspiegel als dielektrische Spiegel gestaltet und weisen Reflektivitätsbereiche auf, die gegeneinander verschoben sind und sich nur in einem Flankenbereich überlappen. Hochreflektierende, dielektrische Spiegel können Reflektivitätsbereiche einer spektralen Breite von zirka 5 bis 10 % einer Grundwellenlänge aufweisen, das heißt, ein dielektrischer Spiegel für eine Wellenlänge von 1000 nm reflektiert in einen Wellenlängenbereich von etwa 950 nm bis 1050 nm. An den Flanken beziehungsweise Kanten dieses Reflektivitätsbereichs fällt die Reflektivität des Spiegels innerhalb einer spektralen Breite von wenigen Nanometern von beispielsweise 99,5 % auf 10 %. Die beiden Reflektivitätsbereiche von Umlenkspiegel und Endspiegel werden so gewählt, dass ein Überlapp der Reflektivitätsbereiche der beiden Spiegel nur in einem schmalen Flankenbereich gegeben ist. Das heißt, beispielsweise nur in einem Wellenlängenbereich von bis zu 5 nm, insbesondere nur bis zu 2 nm oder nur bis zu 1 nm, weisen sowohl Umlenkspiegel als auch Endspiegel eine Reflektivität von beispielsweise mehr als 98 %, bevorzugt von mehr als 99,9 %, auf. Nur in diesem engen Wellenlängenbereich weist der Resonator eine hohe Güte auf. Außerhalb dieses Wellenlängenbereichs ist die Güte des Resonators zu gering, so dass die Verstärkung von Licht außerhalb dieses Wellenlängenbereichs nicht oder nur äußerst eingeschränkt möglich ist. Über eine solche Ausgestaltung von Umlenkspiegel und Endspiegel resultiert ein wellenlängenselektiver Resonator, der gezielt Wellenlängen unterdrückt, die außerhalb eines gewünschten spektralen Bereichs liegen.

Gemäß zumindest einer Ausführungsform des Halbleiterlasers weist das Halbleiterlaserelement eine als Etalon gestaltete Substratschicht auf, wobei die Substratschicht an der dem Umlenkspiegel zugewandten Seite der aktiven Schicht des Halbleiterlaserelements angebracht ist. Die Substratschicht kann ein Wachstumssubstrat sein, auf dem die aktive Schicht oder Schichtenfolge aufgewachsen ist. Auch ist es möglich, dass die Substratschicht die aktive Schicht oder Schichtenfolge mechanisch stützt. Beispielsweise ist das Substrat ein Wachstumssubstrat aus Galliumarsenid oder ein Trägersubstrat aus Germanium, Silizium Siliziumcarbid, Saphir oder Diamant. Bevorzugt weist die Substratschicht eine hohe thermische Leitfähigkeit auf.

Ein Etalon ist ein wellenlängenselektives Element, das auf dem Fabry-Perot-Effekt beruht. Das Etalon wirkt als eine Art Resonator, der nur für bestimmte Wellenlängen durchlässig ist. Der spektrale Abstand zwischen einzelnen, vom Etalon transmittierten Wellenlängen ist abhängig von der Dicke des Etalons und von dessen Brechungsindex. Bevorzugt liegt die Dicke der das Etalon bildenden Substratschicht im Bereich von 20 µm bis 1000 µm, insbesondere im Bereich von 40 µm bis 650 µm. Die Substratschicht kann gleichzeitig als Wärmesenke und Wärmeableiter für die aktive Schicht des Halbleiterlaserelements dienen. Ein solches Etalon ist kompakt, effizient in den Halbleiterlaser integrierbar und dient als zusätzliches wellenlängenselektives Element und ermöglicht eine spektrale Einengung der vom Halbleiterlaserelement emittierten Strahlung der Fundamentalwellenlänge.

Gemäß zumindest einer Ausführungsform des Halbleiterlasers umfasst das Halbleiterlaserelement einen Zusatzresonator, der bevorzugt als Halbleiter-Mikroresonator gestaltet ist. Das bedeutet, auf einer dem Umlenkspiegel zugewandten Seite der aktiven Schicht des Halbleiterlaserelements ist eine dielektrische Schichtenfolge oder eine Schichtenfolge mit einem Halbleitermaterial angebracht, die für die Fundamentalwellenlänge eine definierte Reflektivität aufweist. Auf der dem Umlenkspiegel abgewandten Seite der aktiven Schicht ist eine für mindestens die Fundamentalwellenlänge hochreflektierend ausgestaltete Schicht, beispielsweise in Form eines Bragg-Spiegels, aufgebracht. Dieser Bragg-Spiegel und die Schichtenfolge bilden den Zusatzresonator für die Fundamentalwellenlänge aus. Der Zusatzresonator ist bevorzugt so auf die aktiven Schichten und den Bragg-Spiegel abgestimmt, dass eine Amplitude eines internen Stehwellenfeldes in den aktiven Schichten und im nicht im Halbleiterlaserelement befindlichen Teil des Resonators besonders hoch ist. Der Zusatzresonator unterstützt abhängig von seiner Länge, in Entsprechung eines Etalons, nur bestimmte Wellenlängen und führt zu einer spektralen Einschränkung der Fundamentalwellenlänge.

Ein Halbleiterlaserelement weist, ohne zusätzliche Maßnahmen, im Regelfall eine spektrale Bandbreite im Bereich von etwa 5 nm bis zu einigen 10 nm auf. Bedingt durch die Phasenanpassungsbedingung, das heißt, dass sowohl der Brechungsindex für die Fundamentalwellenlänge als auch der für eine durch Frequenzkonversion erzeugte Wellenlänge in der Ausbreitungsrichtung des Lichts gleich groß sein muss, weist ein optisch nichtlinearer Kristall nur eine geringe spektrale Breite auf, in der die Phasenanpassungsbedingung erfüllt ist. Diese Akzeptanzbreite kann im Bereich von wenigen nm, insbesondere im Bereich von etwa 1 bis 2 nm liegen. Also nur ein geringer Anteil des vom Halbleiterlaserelement emittierten Pumplichts liegt im Akzeptanzbereich bezüglich der Phasenanpassungsbedingung des Kristalls. Mit anderen Worten, die Effizienz der Frequenzkonversion ist aufgrund der vergleichsweise großen Bandbreite des Halbleiterlaserelements gering, da nur ein kleiner Teil der vom Halbleiterlaserelement emittierten Strahlung im Akzeptanzbereich liegt und damit in eine andere Frequenz umgewandelt werden kann.

Eine Effizienzsteigerung der Konversion kann über zusätzliche Maßnahmen erfolgen, über die die Fundamentalwellenlänge des vom Halbleiterlaser emittierten Lichts spektral eingeengt wird, wie beispielsweise über einen polarisationsabhängig reflektierenden Umlenkspiegel in Kombination mit einem λ/2-Element und/oder über Umlenk- und Endspiegel mit gegeneinander verschobenen Reflektivitätsbereichen im Resonator des Halbleiterlasers und/oder über ein zusätzliches frequenzselektives Element im Halbleiterlaserelement. Die Fundamentalwellenlänge wird hierbei bevorzugt spektral so weit eingeengt, dass die spektrale Breite der Fundamentalwellenlänge kleiner oder gleich dem Akzeptanzbereich des Kristalls ist und somit die gesamte Fundamentalwellenlänge für die Frequenzkonversion zur Verfügung steht.

Gemäß zumindest einer Ausführungsform des Halbleiterlasers ist das Halbleiterlaserelement als Halbleiterscheibenlaser ausgestaltet. Der Halbleiterscheibenlaser kann elektrisch oder optisch gepumpt sein und als vertikal emittierender Laser gestaltet sein. Halbleiterscheibenlaser weisen eine geringe Dicke auf und ermöglichen einen kompakten Aufbau des Halbleiterlasers.

Gemäß zumindest einer Ausführungsform des Halbleiterlasers befindet sich der optisch nichtlineare Kristall zwischen Umlenkspiegel und Endspiegel. Hierdurch kann sowohl vom Umlenkspiegel in Richtung Kristall kommende Pumpstrahlung als auch vom Endspiegel in Richtung Kristall zurückreflektierte Anteile der Strahlung der Fundamentalwellenlänge im Kristall zur Frequenzkonversion dienen. Das vom Halbleiterlaserelement emittierte Licht durchläuft also den Kristall mindestens zwei Mal. Hierdurch ist die Effizienz der Frequenzkonversion erhöht.

Gemäß zumindest einer Ausführungsform des Halbleiterlasers ist der Umlenkspiegel als Auskoppelspiegel gestaltet. Das heißt, der Umlenkspiegel ist hochreflektierend für die Fundamentalwellenlänge und teilreflektierend oder transmittierend für die durch Konversion erzeugte Wellenlänge. Der Endspiegel ist in diesem Fall hochreflektierend sowohl für die Fundamentalwellenlänge als auch für die durch Konversion erzeugte Wellenlänge.

Gemäß zumindest einer Ausführungsform des Halbleiterlasers umfasst dieser mindestens ein fokussierendes Element. Das vom Halbleiterlaserelement emittierte Licht wird hierbei bevorzugt entweder in einen Punkt im Kristall oder auf den Endspiegel fokussiert. Ist das Licht der Fundamentalwellenlänge in den Kristall fokussiert, so ist der Endspiegel bevorzugt als fokussierender Spiegel gestaltet. Über die Fokussierung sind höhere Lichtintensitäten der Fundamentalwellenlänge im optisch nichtlinearen Kristall realisierbar, wodurch die Effizienz der Frequenzkonversion erhöht ist.

Gemäß zumindest einer Ausführungsform des Halbleiterlasers umfasst dieser neben dem Halbleiterlaserelement, dem Endspiegel, dem Umlenkspiegel, dem Kristall und dem fokussierenden Element keine weiteren Komponenten. Unter Komponenten werden hierbei insbesondere solche Komponenten verstanden, die eine optische Wirkung aufweisen. Solche Komponenten sind beispielsweise Polarisatoren, Verzögerungsplatten oder Blenden. Durch die Minimierung der Komponentenanzahl kann der Halbleiterlaser kompakt gestaltet sein und es reduzieren sich dessen Herstellungskosten.

Gemäß zumindest einer Ausführungsform des Halbleiterlasers ist der Kristall für eine Frequenzverdopplung der Fundamentalwellenlänge gestaltet. Frequenzverdopplung ist eine effiziente Art der Frequenzkonversion und ermöglicht es, nahinfrarotes Licht in den sichtbaren Spektralbereich umzuwandeln und ein kostengünstiges Leuchtmittel hoher Effizienz zu realisieren.

Gemäß zumindest einer Ausführungsform des Halbleiterlasers liegt die Fundamentalwellenlänge im nahinfraroten Spektralbereich zwischen 780 nm und 1550 nm. Bevorzugt emittiert das Halbleiterlaserelement eine Fundamentalwellenlänge im Bereich zwischen 900 nm und 1100 nm. Fundamentalwellenlängen in diesem Spektralbereich sind von Halbleiterlaserelementen mit hohem Wirkungsgrad effizient erzeugbar und liefern beispielsweise verdoppeltes Licht im blauen, grünen oder roten Spektralbereich.

Gemäß zumindest einer Ausführungsform des Halbleiterlasers weist der optisch nichtlineare Kristall eine geometrische Länge zwischen einschließlich 1 und 10 mm, bevorzugt zwischen 2 mm und 6 mm, insbesondere zwischen 3 mm und 5 mm auf. Unter geometrischer Länge wird diejenige Ausdehnung des Kristalls verstanden, die in Strahlrichtung liegt, also beispielsweise parallel zum Licht der Fundamentalwellenlänge.

Gemäß zumindest einer Ausführungsform des Halbleiterlasers ist der Winkel zwischen einem von Halbleiterlaserelement und Umlenkspiegel gebildeten Resonatorarm und einem von Endspiegel und Umlenkspiegel gebildeten Resonatorarm in einem Bereich von einschließlich 60° bis 120°. Bevorzugt beträgt der Winkel zwischen den beiden Resonatorarmen zirka 90°. Für diesen Winkelbereich sind Umlenkspiegel, die eine hohe Polarisationsselektivität aufweisen, kostengünstig herstellbar. Insbesondere bei einem Winkel von 90° erleichtert sich die Justage des Halbleiterlasers.

Gemäß zumindest einer Ausführungsform des Halbleiterlasers beträgt die spektrale Breite der Fundamentalwellenlänge höchstens 3 nm, bevorzugt höchstens 1 nm, insbesondere höchstens 0,3 nm. Als spektrale Breite wird hierbei die volle Breite des Spektrums auf halber Höhe des Maximums, auch als FWHM bekannt, definiert. Solche geringen spektralen Breiten der Fundamentalwellenlänge liegen in der Größenordnung des Akzeptanzbereichs des optisch nichtlinearen Kristalls und ermöglichen eine effiziente Frequenzkonversion.

Gemäß zumindest einer Ausführungsform des Halbleiterlasers beträgt die geometrische Gesamtlänge höchstens 25 mm, bevorzugt höchstens 15 mm, insbesondere höchstens 10 mm. Als Gesamtlänge ist die geometrische Strecke definiert, die der Resonatorlänge des Halbleiterlasers entspricht. Diese Strecke entspricht dem Lichtlaufweg von Endspiegel über Umlenkspiegel bis zu der hochreflektierenden Schicht des Halbleiterlaserelements, die sich auf der dem Umlenkspiegel abgewandten Seite der aktiven Schicht des Halbleiterlaserelements befindet. Derartige Gesamtlängen des Halbleiterlasers beziehungsweise dessen Resonators ermöglichen eine kompakte Bauweise des Halbleiterlasers sowie ein hohes Maß an Stabilität und Robustheit gegenüber äußeren Umwelteinflüssen wie beispielsweise Temperaturschwankungen.

Gemäß zumindest einer Ausführungsform des Halbleiterlasers weist dieser eine Wärmesenke auf, auf der das Halbleiterlaserelement angebracht ist. Weiterhin kann der Halbleiterlaser eine Monitordiode aufweisen, über die die vom Halbleiterlaserelement emittierte Leistung und/oder Wellenlänge gemessen und/oder geregelt werden kann. Als weitere Option kann der Halbleiterlaser eine Temperaturregeleinheit aufweisen, über die die Temperatur von Halbleiterlaserelement und/oder optisch nichtlinearem Kristall eingestellt werden kann. Über die kumulative oder alternative Verwendung solcher Komponenten kann die Abstrahlcharakteristik des frequenzgemischten Lichts des Halbleiterlasers geregelt und/oder stabilisiert werden. Nachfolgend wird ein hier beschriebener Halbleiterlaser unter Bezugnahme auf die Zeichnung anhand von Ausführungsbeispielen näher erläutert. Gleiche Bezugzeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:
- Figur 1: eine schematische Draufsicht eines Ausführungsbeispiels eines hier beschriebenen Halbleiterlasers,
- Figur 2: eine schematische Draufsicht eines Ausführungsbeispiels eines hier beschriebenen Halbleiterlasers mit Wärmesenke,
- Figur 3: eine schematische Seitenansicht eines Ausführungsbeispiels eines hier beschriebenen Halbleiterlaserelements mit Zusatzresonator, und
- Figur 4: eine schematische Seitenansicht eines Ausführungsbeispiels eines hier beschriebenen Halbleiterlaserelements mit einem Etalon,
- Figur 5: eine schematische Seitenansicht eines Ausführungsbeispiels eines hier beschriebenen Halbleiterlaserelements, und
- Figur 6: eine schematische Darstellung von Reflexionskurven von Ausführungsbeispielen von hier beschriebenen Halbleiterlaserlementen.

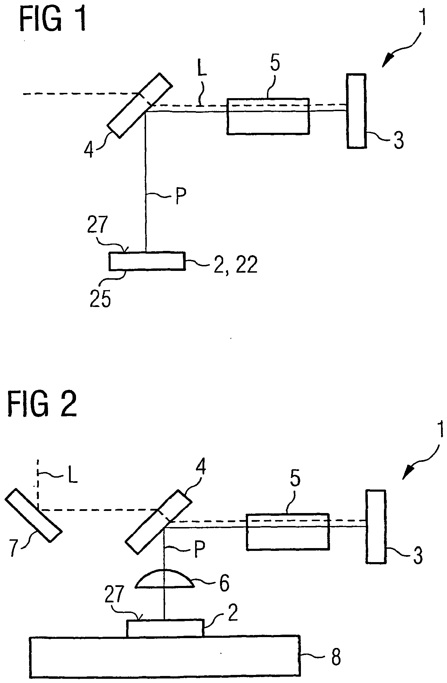

In Figur 1 ist ein Ausführungsbeispiel eines Halbleiterlasers 1 dargestellt. Ein Halbleiterlaserelement 2 emittiert Licht einer Fundamentalwellenlänge P von einer Lichtaustrittsfläche 27 in Richtung eines Umlenkspiegels 4. Vom Umlenkspiegel 4 wird das Pumplicht P in Richtung eines Endspiegels 3 gelenkt. Zwischen Umlenkspiegel 4 und Endspiegel 3 befindet sich ein optisch nichtlinearer Kristall 5, der für eine Typ II-Frequenzkonversion gestaltet ist. Der Umlenkspiegel 4 weist für Licht der Fundamentalwellenlänge P, das senkrecht zur Einfallsebene polarisiert ist, eine Reflektivität von mindestens 99 % auf, für parallel polarisiertes Licht höchstens 80 %.

Vom Umlenkspiegel 4 kommendes Pumplicht P, symbolisiert durch eine durchgezogene Linie, wird vom Kristall 5 mindestens zum Teil in durch eine gestrichelte Linie symbolisiertes Licht L einer anderen Wellenlänge über Frequenzkonversion, zum Beispiel Frequenzverdopplung, umgewandelt. Dieses Licht L läuft gemeinsam mit dem Anteil an nicht umgewandeltem Pumplicht P weiter in Richtung Endspiegel 3. Sowohl das umgewandelte Licht L als auch der verbleibende Teil der Fundamentalstrahlung P werden vom Endspiegel 3 zurück in Richtung Kristall 5 und Umlenkspiegel 4 reflektiert. Das noch vorhandene Fundamentallicht P durchläuft den Kristall 5 ein zweites Mal, wodurch die Effizienz der Frequenzkonversion erhöht wird, da nochmals Fundamentalstrahlung P in Licht L umgewandelt wird. Das Licht L wird vom Umlenkspiegel 4, der auch als Auskoppelspiegel gestaltet ist, transmittiert. Licht der Fundamentalwellenlänge P wird vom Umlenkspiegel 4 zurück in Richtung zum Halbleiterlaserelement 2 reflektiert.

Das Halbleiterlaserelement 2 weist eine aktive Schicht oder eine aktive Schichtenfolge 22 auf, die im Betrieb Licht P mit der Fundamentalwellenlänge emittiert. An einer dem Umlenkspiegel 4 abgewandten Seite der aktiven Schicht 22 ist eine für die Fundamentalwellenlänge P hoch reflektierende Schicht, beispielsweise in Form eines Bragg-Spiegels 25, kurz DBR, angebracht. Diese hoch reflektierende Schicht bildet zusammen mit dem Endspiegel 3 die Endspiegel des Resonators des Halbleiterlasers 1. Die geometrische Länge des Resonators von hochreflektierendem Bragg-Spiegel 25 bis zum Endspiegel 3 beträgt zirka 10 mm.

Beim Ausführungsbeispiel gemäß Figur 2 umfasst der Halbleiterlaser 1 zusätzlich ein fokussierendes Element 6 sowie eine Wärmesenke 8. Das fokussierende Element 6 ist als Linse ausgestaltet und fokussiert die Strahlung P auf den Endspiegel 3. Da sich der optisch nichtlineare Kristall 5 in der Nähe des Endspiegels 3 befindet, ist die Strahlung P im Kristall 5 nahezu fokussiert. Hierdurch werden höhere optische Leistungsdichten der Strahlung der Fundamentalwellenlänge P im Kristall 5 erzielt, so dass auch die Frequenzkonversion effizienter abläuft.

Das Halbleiterlaserelement 2, das als Halbleiterscheibenlaser ausgeführt sein kann, ist auf der Wärmesenke 8 angebracht. Über die Wärmesenke 8 kann im Betrieb des Halbleiterlaserelements 2 entstehende Wärme von diesem effizient abgeführt werden.

Das über dem als Auskoppelspiegel gestalteten Umlenkspiegel 4 aus dem Halbleiterlaser 1 gelangende umgewandelte Licht L trifft nachfolgend auf einen Spiegel 7, über den das Licht L in einen gewünschten Raumbereich gelenkt wird. Der Spiegel 7 kann als fokussierendes optisches Element gestaltet sein.

Der Kristall 5 hat eine geometrische Länge in Strahlrichtung von zirka 4 mm. Mögliche Kristallmaterialien sind etwa, in Abhängigkeit von dem zu erzielenden Frequenzbereich und von der Fundamentalwellenlänge, KTP, LBO oder BBO. Bei einer Fundamentalwellenlänge der Strahlung P von zirka 1000 nm beträgt der spektrale Abstand zwischen Wellenlängen, die durch den Kristall 5 aufgrund eines λ/2-Effekts keine Änderung der Polarisationsrichtung erfahren, zirka 1 nm bis 2 nm. Über den Umlenkspiegel 4, der senkrecht polarisiertes Licht der Pumpstrahlung P reflektiert, für parallel polarisiertes Licht der Pumpstrahlung P allerdings deutlich schlechter reflektiert, werden vom Resonator des Halbleiterlasers 1 nur solche Wellenlängen, die nach Durchlaufen des Kristalls 5 dieselbe Polarisationsrichtung haben als vor dem Durchlaufen des Kristalls 5, unterstützt. Dies ergibt eine effektive Einschränkung der Wellenlänge der Pumpstrahlung P auf solche Wellenlängen, für die der Kristall 5 die Polarisationsrichtung effektiv nicht dreht.

Alternativ oder zusätzlich können die als dielektrische Spiegel ausgeführten Spiegel Endspiegel 3 und Umlenkspiegel 4 Reflektivitätsbereiche aufweisen, die sich nur in einem schmalen Spektralbereich überlappen. Hierdurch kann eine weitere Wellenlängenselektivität des Halbleiterlasers 1 bezüglich der Fundamentalwellenlänge der Strahlung P erzielt werden. Es ist möglich, dass die vom Halbleiterlaserelement 2 emittierte Strahlung P somit eine spektrale Breite aufweist, die kleiner oder vergleichbar ist mit einer für die Frequenzkonversion relevanten Akzeptanzbreite des Kristalls 5 aufgrund einer Phasenanpassungsbedingung.

Weiterhin kann das Halbleiterlaserelement 2 derart gestaltet sein, dass die spektrale Breite der Strahlung der Fundamentalwellenlänge P, die vom Halbleiterlaserelement 2 emittiert wird, bereits durch das Halbleiterlaserelement 2 selbst mindestens zum Teil eingeschränkt ist.

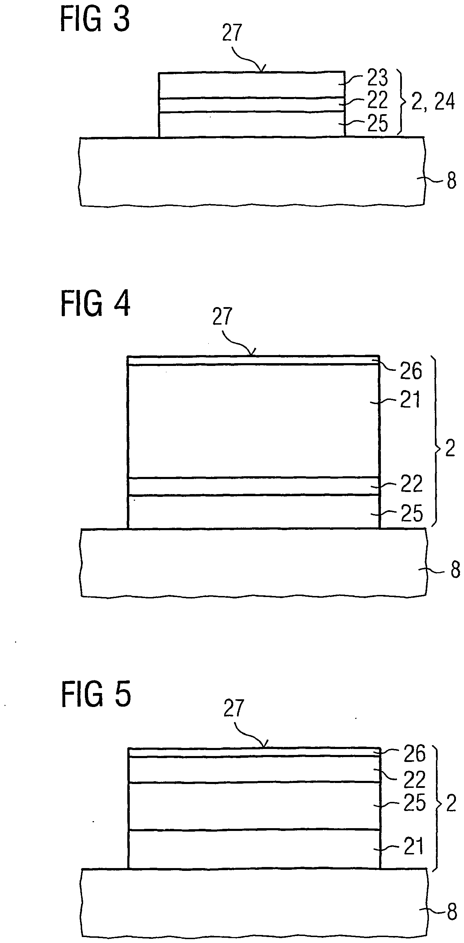

In Figur 3 ist ein Halbleiterlaserelement 2 eines Halbleiterlasers 1 dargestellt, der auf einer Wärmesenke 8 angebracht ist. Von der der Lichtaustrittsfläche 27 zugewandten Hauptseite der Wärmesenke 8 weist der Halbleiterlaserelement 2 zuerst eine hochreflektierende, als Bragg-Spiegel 25 gestaltete Schichtenfolge auf, auf die die aktive Schicht beziehungsweise Schichtenfolge 22 folgt, auf der eine weitere dielektrische oder Halbleiterschichtenfolge 23 angebracht ist, von der auch die Lichtaustrittsfläche 27 gebildet ist. Für die optische Funktion nicht vorrangig relevante Komponenten, wie etwa Stromzuführungen oder eine Pumplichtquelle zum optischen Pumpen des Halbleiterlaserelements 2, sind der Übersichtlichkeit halber in den Figuren nicht dargestellt.

Die Schichtenfolge 23 ist so ausgestaltet, dass sie teilreflektierend für die von der aktiven Schicht 22 erzeugte Strahlung wirkt. Somit bildet die Schichtenfolge 23 zusammen mit dem Bragg-Spiegel 25 einen Zusatzresonator 24 aus, in dem sich die aktive Schicht 22 befindet. Die optische Länge des Zusatzresonators 24 liegt in der Größenordnung der Fundamentalwellenlänge der Strahlung P. Der Zusatzresonator 24 weist somit eine um mehrere Größenordnungen kleinere Länge auf als der gesamte Resonator des Halbleiterlasers 1, dessen Länge im Millimeterbereich liegt. Der Zusatzresonator 24 stellt ein Fabry-Perot-Element dar, das nur solche Wellenlängen unterstützt, die einem ganzzahligen Vielfachen der halben Fundamentalwellenlänge entsprechen. Die aktive Schicht 22 hat einen spektralen Verstärkungsbereich, ohne zusätzliche Maßnahmen, der eine Bandbreite von zirka 10 nm aufweist. Über den Fabry-Perot-Effekt des Zusatzresonators 24 werden bestimmte Fundamentalwellenlängen selektiert, als zusätzliche oder alternative Maßnahme zu den beispielsweise im Ausführungsbeispiel gemäß Figur 2 beschriebenen Wellenlängen einschränkenden Maßnahmen.

Halbleiterlaserelement ohne spektrale Einengung der Verstärkungsbandbreite weisen einen Bragg-Spiegel 25 auf, auf dem eine aktive Schicht 22 aufgebracht ist. Die Lichtaustrittsfläche 27 wird durch ein Material der aktiven Schicht oder des aktiven Schichtenstapels 22 gebildet. Durch den typischerweise großen Brechungsindexunterschied zwischen Luft und diesem Material wird ein hoher Anteil des in der aktiven Schicht 22 erzeugten Lichts der Fundamentalwellenlänge P an der Lichtaustrittsfläche 27 zurück in das Halbleiterlaserelement 2 reflektiert. Hierdurch bildet sich eine hohe Strahlungsintensität im Halbleiterlaserelement 2 aus, jedoch ist die Strahlungsintensität im Resonator des Halbleiterlasers 1 außerhalb des Halbleiterlaserelements 2 nur vergleichsweise gering. Hierdurch ist die Effizienz der Frequenzkonversion vermindert.

Durch die hohe Reflektivität der Grenzschicht kommt es ebenfalls zu einer stärkeren Kopplung zwischen dem von Bragg-Spiegel 25 und Lichtaustrittsfläche 27 gebildeten Resonator des Halbleiterlaserelements 2, dessen Länge im Bereich der Fundamentalwellenlänge der Strahlung P liegt, und dem Rest des Resonators des Halbleiterlasers 1, dessen Länge im Millimeterbereich liegt. Durch diese starke Kopplung zwischen diesen beiden Resonatorteilen kann es zu starken optischen Leistungsschwankungen im Betrieb des Halbleiterlasers 1 kommen.

Durch die dielektrische Schichtenfolge 23, wie im Ausführungsbeispiel gemäß Figur 3 gezeigt, kann die Reflektivität des Zusatzresonators gezielt in einem weiten Wertebereich eingestellt werden. Die Reflektivität für Licht der Pumpstrahlung P der dielektrischen Schichtenfolge 23 liegt bevorzugt im Bereich von 20 % bis 60 %, insbesondere bei zirka 30 %. Weiterhin kann über die Schichtenfolge 23 die genaue Länge des Zusatzresonators 24 und somit die von diesem unterstützte Fundamentalwellenlänge der Strahlung P eingestellt werden.

Bei nicht spektral eingeengten Halbleiterlaserelement 2 ohne Schichtenfolge 23 ist die Güte der von Bragg-Spiegel 25 und Lichtaustrittsfläche 27 gebildeten resonatorähnlichen Struktur stark beeinflusst von den Herstellungstoleranzen der aktiven Schicht 22, den thermischen Ausdehnungskoeffizienten, der elektrischen und thermischen Leitfähigkeit der Schicht 22 sowie deren Abhängigkeit des Brechungsindexes von der Temperatur. Dies erfordert einen hohen Herstellungsaufwand, da eine hohe Fertigungspräzision erforderlich ist, um alle Parameter entsprechend einzustellen. Durch die Verwendung einer Schichtenfolge 23 oder auch einer Substratschicht 21 gemäß Figur 4, können die Herstellungstoleranzen erhöht werden und der Halbleiterlaser ist im Betrieb unempfindlicher gegenüber äußeren Störungen.

Beim Ausführungsbeispiel gemäß Figur 4 weist der Halbleiterlaserelement 2 eine Substratschicht 21 aus etwa Galliumarsenid auf, die auf der der Lichtaustrittsfläche 27 zugewandten Seite der aktiven Schicht 22 aufgebracht ist. Die Substratschicht 21 ist für die Wellenlänge der Pumpstrahlung P bevorzugt transparent. Die Dicke der Substratschicht 21 kann beispielsweise über Schleifen, Polieren und/oder Ätzen eingestellt werden. Über den Sprung des Brechungsindex zwischen Substratschicht 21 und aktiver Schicht 22 einerseits sowie zwischen Substratschicht 21 und der das Halbleiterlaserelement 2 umgebenden Luft andererseits, bildet die Substratschicht 21 wiederum ein wellenlängenselektives, auf dem Fabry-Perot-Effekt beruhendes Etalon. Über die Dicke der Substratschicht 21 können die vom Etalon unterstützten Wellenlängen gezielt eingestellt werden. Da der Brechungsindex der Substratschicht 21 zwischen dem von Luft und dem der aktiven Schicht 22 liegen kann, kann auch die Reflektivität der Lichtaustrittsfläche 27 im Vergleich zu einem Halbleiterlaserelement 2 ohne eine solche Substratschicht 21 vergleichsweise gering sein, so dass eine hohe Intensität des Lichts der Fundamentalwellenlänge P in Resonatorbereichen außerhalb des Halbleiterlaserelements 2 gewährleistet ist.

Die Substratschicht 21 kann auch als Wachstumssubstrat für die aktive Schicht 22 dienen. Weiterhin kann über die Substratschicht 21 ebenfalls aus dem Betrieb des Halbleiterlaserelements 2 resultierende Wärme abgeführt werden. Auf der der Wärmesenke 8 abgewandten Seite der Substratschicht 21 kann optional eine Beschichtung 26 aufgebracht sein, über die die Reflektivität der Lichtaustrittsfläche 27 zusätzlich eingestellt werden kann. Optional kann die Beschichtung 26 auch hochreflektierend für das aus dem Licht der Fundamentalwellenlänge P erzeugte konvertierte Licht L sein.

Beim Ausführungsbeispiel des Halbleiterlaserelements 2 gemäß Figur 5 ist die Substratschicht 21 auf der Wärmesenke 8 angebracht. Der Bragg-Spiegel 25 befindet sich zwischen der Substratschicht 21 und der aktiven Schicht 22, die auf einer der Substratschicht 21 abgewandten Seite des Bragg-Spiegels 25 aufgebracht ist. Die Lichtaustrittsfläche 27 ist optional durch die Beschichtung 26 gebildet.

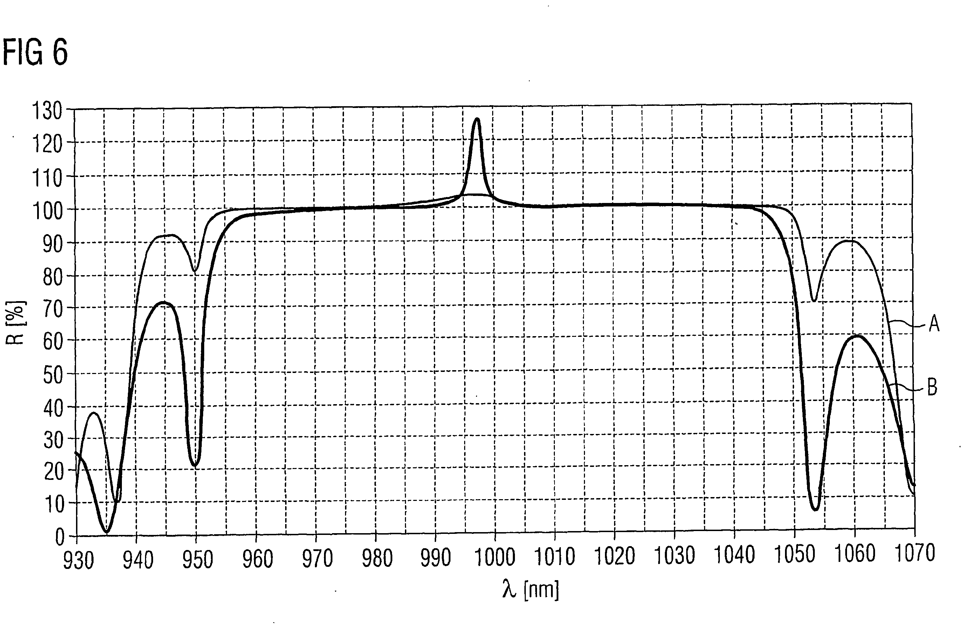

In Figur 6 ist eine Reflektivität R eines Halbleiterlaserelements 2 mit der Schichtenfolge 23 gemäß Figur 3, siehe Kurve B in Figur 6, und die Reflektivität R eines Halbleiterlaserelements 2, zum Beispiel gemäß Figur 5, ohne eine solche Schichtenfolge 23 dargestellt, siehe Kurve A in Figur 6. Die Reflektivität R ist gegenüber der Wellenlänge λ aufgetragen. Eine Reflektivität R von mehr als 100 % entspricht einer Verstärkung durch das Halbleiterlaserelement 2. Die Verstärkung zeigt ein Maximum bei etwa 998 nm. Im Spektralbereich zwischen zirka 960 nm und 1040 nm beträgt die Reflektivität R knapp 100 %, im Wesentlichen bestimmt durch die Güte des Bragg-Spiegels 25.

Ohne die Schichtenfolge 23 beträgt eine spektrale Halbwertsbreite, FWHM, der Verstärkung des Halbleiterlaserelements zirka 10 nm, siehe Kurve A, und ist signifikant größer als der Akzeptanzbereich eines nichtlinearen Kristalls 5. Durch die Schichtenfolge 23, siehe Kurve B, ist die spektrale Breite der Verstärkung auf etwa 2,5 nm reduziert. Zudem ist die Verstärkung mit Schichtenfolge 23 deutlich erhöht und liegt bei zirka 126 %, im Vergleich zu zirka 104 % ohne Schichtenfolge 23.

## Patentansprüche

1. Halbleiterlaser (1) mit
- einem Halbleiterlaserelement (2), das im Betrieb elektromagnetische Strahlung mit mindestens einer Fundamentalwellenlänge emittiert,
- einem Endspiegel (3),
- einem Umlenkspiegel (3), der sich zwischen dem Halbleiterlaserelement (2) und dem Endspiegel (3) befindet, und
- mindestens einem optisch nichtlinearen Kristall (5), der sich zwischen dem Umlenkspiegel (4) und dem Endspiegel (3) befindet,
**dadurch gekennzeichnet, dass**
der Umlenkspiegel (4) polarisationsabhängig reflektierend ausgestaltet ist und der optisch nichtlineare Kristall (5) für eine Frequenzkonversion vom Typ II der Fundamentalwellenlänge gestaltet ist und der eine λ/2-Bedingung für die Fundamentalwellenlänge erfüllt,
wobei λ/2-Bedingung bedeutet, dass der optisch nichtlineare Kristall (5) eine solche Länge hat, dass ein Laufzeitunterschied zwischen ordentlich und außerordentlich polarisierten Komponenten der Strahlung der Fundamentalwellenlänge im optisch nichtlinearen Kristall (5) einem ganzzahligen Vielfachen einer halben Wellenlänge der Fundamentalwellenlänge entspricht.

2. Halbleiterlaser (1) nach Anspruch 1,
bei dem Endspiegel (3) und Umlenkspiegel (4) als dielektrische Spiegel gestaltet und deren Reflektivitätsbereiche gegeneinander verschoben sind und sich nur in einem Flankenbereich überlappen.

3. Halbleiterlaser (1) nach Anspruch 1 oder 2,
bei dem das Halbleiterlaserelement (2) eine als Etalon gestaltete Substratschicht (21) umfasst, die auf einer dem Umlenkspiegel zugewandten Seite einer aktiven Schicht (22) des Halbleiterlaserelements (2) angebracht ist.

4. Halbleiterlaser (1) nach Anspruch 1 oder 2,
bei dem das Halbleiterlaserelement (2) einen Zusatzresonator (24) mit einer dielektrischen Schichtenfolge (23) umfasst, die auf der dem Umlenkspiegel (4) zugewandten Seite der aktiven Schicht (22) des Halbleiterlaserelements (2) angebracht ist.

5. Halbleiterlaser (1) nach einem der vorhergehenden Ansprüche,
bei dem das Halbleiterlaserelement (2) als Halbleiterscheibenlaser ausgestaltet ist.

6. Halbleiterlaser (1) nach einem der vorhergehenden Ansprüche,
der dazu eingerichtet ist, im Betrieb Licht im grünen Spektralbereich zu erzeugen.

7. Halbleiterlaser (1) nach einem der vorhergehenden Ansprüche,
bei dem der Umlenkspiegel (4) als Auskoppelspiegel gestaltet ist.

8. Halbleiterlaser (1) nach einem der vorhergehenden Ansprüche,
der mindestens ein fokussierendes Element (6) umfasst, so dass das Licht der Fundamentalwellenlänge auf einen Punkt im optisch nichtlinearen Kristall (5) oder auf den Endspiegel (3) fokussiert ist.

9. Halbleiterlaser (1) nach einem der vorhergehenden Ansprüche,
der neben Halbleiterlaserelement (2), Endspiegel (3), Umlenkspiegel (4), optisch nichtlinearen Kristall (5) und fokussierendem Element (6) keine weiteren Komponenten, die eine optische Wirkung aufweisen, umfasst.

10. Halbleiterlaser (1) nach einem der vorhergehenden Ansprüche,
bei dem der Kristall (5) für eine Frequenzverdopplung der Fundamentalwellenlänge gestaltet ist.

11. Halbleiterlaser (1) nach einem der vorhergehenden Ansprüche,
bei dem die Fundamentalwellenlänge zwischen 820 nm und 1350 nm liegt.

12. Halbleiterlaser (1) nach einem der vorhergehenden Ansprüche,
bei dem der optisch nichtlinearen Kristall (5) eine geometrische Länge zwischen einschließlich 1 mm und 10 mm aufweist.

13. Halbleiterlaser (1) nach einem der vorhergehenden Ansprüche,
bei dem der Winkel zwischen einem von Halbleiterlaserelement (2) und Umlenkspiegel (4) gebildeten Resonatorarm (8a) und einem von Endspiegel (3) und Umlenkspiegel (4) gebildeten Resonatorarm (8b) in einem Bereich von einschließlich 60° bis 120° liegt.

14. Halbleiterlaser (1) nach einem der vorhergehenden Ansprüche,
bei dem die spektrale Breite der Fundamentalwellenlänge kleiner oder gleich 0,3 nm ist.

15. Halbleiterlaser (1) nach einem der vorhergehenden Ansprüche,
dessen geometrische Gesamtlänge kleiner oder gleich 25 mm ist.

## Claims

1. A semiconductor laser (1) with
- a semiconductor laser element (2), which emits electromagnetic radiation with at least one fundamental wavelength when in operation,
- an end mirror (3),
- a deflecting mirror (4), which is located between the semiconductor laser element (2) and the end mirror (3), and
- at least one optically nonlinear crystal (5), which is located between the deflecting mirror (4) and the end mirror (3),
**characterised in that**
the deflecting mirror (4) is reflective as a function of polarisation and the optically nonlinear crystal (5) is configured for type II frequency conversion of the fundamental wavelength and satisfies a λ/2 condition for the fundamental wavelength,
λ/2 condition meaning that the optically nonlinear crystal (5) is of such a length that the difference in transit time between ordinarily and extraordinarily polarised components of the radiation of fundamental wavelength in the optically nonlinear crystal (5) corresponds to an integral multiple of half the wavelength of the fundamental wavelength.

2. A semiconductor laser (1) according to claim 1,
in which end mirror (3) and deflecting mirror (4) take the form of dielectric mirrors and their reflectivity regions are displaced relative to one another and overlap only in a flank region.

3. A semiconductor laser (1) according to claim 1 or claim 2,
in which the semiconductor laser element (2) comprises a substrate layer (21) configured as an etalon, which is mounted on a side facing the deflecting mirror of an active layer (22) of the semiconductor laser element (2).

4. A semiconductor laser (1) according to claim 1 or claim 2,
in which the semiconductor laser element (2) comprises a supplementary resonator (24) with a dielectric layer sequence (23), which is mounted on the side of the active layer (22) of the semiconductor laser element (2) facing the deflecting mirror (4).

5. A semiconductor laser (1) according to any one of the preceding claims,
in which the semiconductor laser element (2) takes the form of a semiconductor disc laser.

6. A semiconductor laser (1) according to any one of the preceding claims,
which is set up to generate light in the green spectral range when in operation.

7. A semiconductor laser (1) according to any one of the preceding claims,
in which the deflecting mirror (4) takes the form of an outcoupling mirror.

8. A semiconductor laser (1) according to any one of the preceding claims,
which comprises at least one focusing element (6), such that the light of the fundamental wavelength is focused onto a point in the optically nonlinear crystal (5) or onto the end mirror (3).

9. A semiconductor laser (1) according to any one of the preceding claims,
which does not comprise any further components which have an optical effect apart from semiconductor laser element (2), end mirror (3), deflecting mirror (4), optically nonlinear crystal (5) and focusing element (6).

10. A semiconductor laser (1) according to any one of the preceding claims,
in which the crystal (5) is configured for frequency doubling of the fundamental wavelength.

11. A semiconductor laser (1) according to any one of the preceding claims,
in which the fundamental wavelength is between 820 nm and 1350 nm.

12. A semiconductor laser (1) according to any one of the preceding claims,
in which the optically nonlinear crystal (5) has a geometric length of between 1 mm and 10 mm inclusive.

13. A semiconductor laser (1) according to any one of the preceding claims,
in which the angle between a resonator arm (8a) formed by semiconductor laser element (2) and deflecting mirror (4) and a resonator arm (8b) formed by end mirror (3) and deflecting mirror (4) is in a range from 60° to 120° inclusive.

14. A semiconductor laser (1) according to any one of the preceding claims,
in which the spectral width of the fundamental wavelength is less than or equal to 0.3 nm.

15. A semiconductor laser (1) according to any one of the preceding claims,
whose total geometric length is less than or equal to 25 mm.

## Revendications

1. Laser à semi-conducteur (1) comprenant
- un élément laser à semi-conducteur (2) qui, en fonctionnement, émet un rayonnement électromagnétique avec au moins une longueur d'onde fondamentale,
- un miroir final (3),
- un miroir de déviation (4) qui se trouve entre l'élément laser à semi-conducteur (2) et le miroir final (3), et
- au moins un cristal (5) optiquement non linéaire qui se trouve entre le miroir de déviation (4) et le miroir final (3),
**caractérisé en ce que**
le miroir de déviation (4) est réalisé de manière réfléchissante en fonction de la polarisation et **en ce que** le cristal (5) optiquement non linéaire est réalisé pour une conversion de fréquence du type II de la longueur d'onde fondamentale et remplit une condition λ/2 pour la longueur d'onde fondamentale,
condition λ/2 signifiant que le cristal (5) optiquement non linéaire a une telle longueur qu'une différence du temps de propagation entre des composants, polarisés de manière ordinaire et de manière extraordinaire, du rayonnement de la longueur d'onde fondamentale dans le cristal (5) optiquement non linéaire correspond à un multiple entier d'une demi-longueur d'onde de la longueur d'onde fondamentale.

2. Laser à semi-conducteur (1) selon la revendication 1, dans lequel le miroir final (3) et le miroir de déviation (4) sont réalisés en tant que miroirs diélectriques et dont les plages de réflexibilité sont déplacées les unes par rapport aux autres et se chevauchent seulement dans une zone de flanc.

3. Laser à semi-conducteur (1) selon la revendication 1 ou 2,
dans lequel l'élément laser à semi-conducteur (2) comprend une couche de substrat (21) réalisée comme étalon, laquelle est placée sur un côté, tourné vers le miroir de déviation, d'une couche active (22) de l'élément laser à semi-conducteur (2).

4. Laser à semi-conducteur (1) selon la revendication 1 ou 2,
dans lequel l'élément laser à semi-conducteur (2) comprend un résonateur supplémentaire (24) muni d'une suite de couches diélectriques (23), laquelle est placée sur le côté, tourné vers le miroir de déviation (4), de la couche active (22) de l'élément laser à semi-conducteur (2).

5. Laser à semi-conducteur (1) selon l'une quelconque des revendications précédentes,
dans lequel l'élément laser à semi-conducteur (2) est réalisé en tant que laser à tranche.

6. Laser à semi-conducteur (1) selon l'une quelconque des revendications précédentes,
qui est configuré pour générer, en fonctionnement, de la lumière dans le domaine spectral vert.

7. Laser à semi-conducteur (1) selon l'une quelconque des revendications précédentes,
dans lequel le miroir de déviation (4) est réalisé comme miroir de découplage.

8. Laser à semi-conducteur (1) selon l'une quelconque des revendications précédentes,
qui comprend au moins un élément focalisant (6), de sorte que la lumière de la longueur d'onde fondamentale est focalisée sur un point dans le cristal (5) optiquement non linéaire ou sur le miroir final (3).

9. Laser à semi-conducteur (1) selon l'une quelconque des revendications précédentes,
qui, outre l'élément laser à semi-conducteur (2), le miroir final (3), le miroir de déviation (4), le cristal (5) optiquement non linéaire et l'élément focalisant (6), ne comprend pas d'autres composants présentant un effet optique.

10. Laser à semi-conducteur (1) selon l'une quelconque des revendications précédentes,
dans lequel le cristal (5) est réalisé pour un doublage de fréquence de la longueur d'onde fondamentale.

11. Laser à semi-conducteur (1) selon l'une quelconque des revendications précédentes,
dans lequel la longueur d'onde fondamentale est située entre 820 nm et 1350 nm.

12. Laser à semi-conducteur (1) selon l'une quelconque des revendications précédentes,
dans lequel le cristal (5) optiquement non linéaire présente une longueur géométrique située entre y compris 1 mm et 10 mm.

13. Laser à semi-conducteur (1) selon l'une quelconque des revendications précédentes,
dans lequel l'angle compris entre un bras de résonateur (8a) formé par l'élément laser à semi-conducteur (2) et le miroir de déviation (4) et un bras de résonateur (8b) formé par le miroir final (3) et le miroir de déviation (4)est situé dans une plage allant de 60° compris à 120°.

14. Laser à semi-conducteur (1) selon l'une quelconque des revendications précédentes,
dans lequel la largeur spectrale de la longueur d'onde fondamentale est inférieure ou égale à 0,3 nm.

15. Laser à semi-conducteur (1) selon l'une quelconque des revendications précédentes,
dont la longueur géométrique totale est inférieure ou égale à 25 mm.
